# EUROPEAN PATENT SPECIFICATION

(11) **EP 1 406 384 B1**
(45) Date of publication and mention of the grant of the patent: **25.05.2005**
(21) Application number: 02447187.2
(22) Date of filing: 01.10.2002
(51) Int. Cl.: H03H 7/42, H03H 7/46

(54) **Reverse gain saving broadband RF couplers**
Breitband HF Richtkoppler mit Rückwärts-Leistungseinsparung
Coupleur HF à large bande à gain inverse économisé

(43) Date of publication of application: 07.04.2004
(73) Proprietor: Dinh-Debouny, Huu-Tung, 4430 Ans (BE)
(72) Inventor: Dinh-Debouny, Huu-Tung, 4430 Ans (BE)
(74) Representative: Van Malderen, Michel

(56) References cited:
- EP-A- 0 827 297

## Description

### Field of the invention

The present invention is related to new broadband RF directional couplers with low reverse (or return) insertion loss for use in the field of cable teledistribution also called collective antenna television or cable TV (CATV).

### Technological background and prior art

Owing to the huge opportunities the onset of telecommunications deregulation has opened up for network operators, hybrid fiber coaxial cable (HFC) is getting today to be widespread in the field of integrated high frequency broadband services (analog and digital video, video-on-demand, up- and downstream data, cable telephony). HFC comprises a telecommunication cable mixing optical fiber cable and coaxial cable as different portions of a network carrying broadband content, such as video, data and voice.

Typically, a local cable operator (CATV) company may use fiber optic cable from a cable head-end or serving hub (distribution center) to serving nodes, called HFC nodes, located near business and/or residential users, called hereinafter subscribers, and then use coaxial cable from these nodes to such subscribers. HFC technology brings the advantage to make available to the final user some of the well-known fiber optic cable characteristics, such as high bandwidth and low noise (or low interference) susceptibility, without having to replace the entire existing coaxial cable network which is already installed.

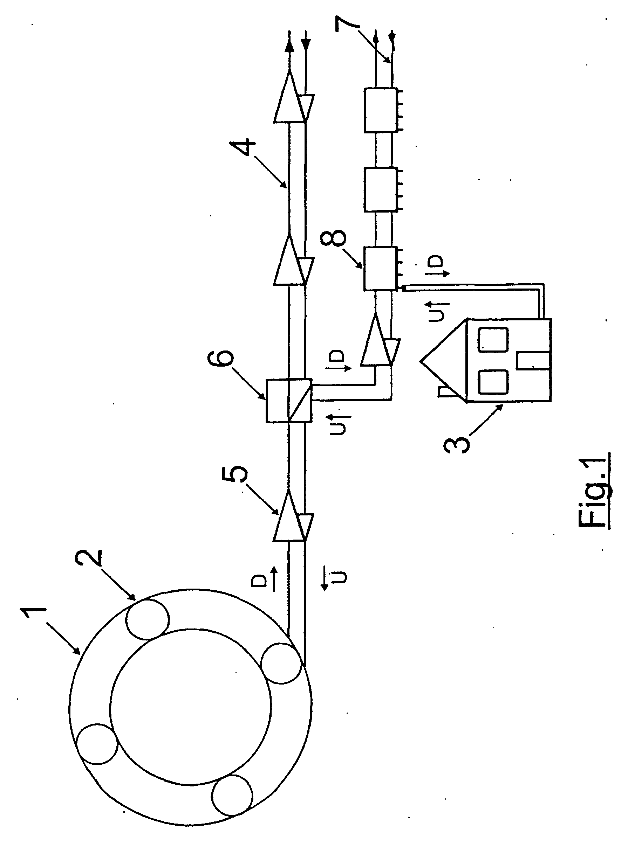

Figure 1 shows a typical 2-fibers ring 1 which constitutes a backbone of HFC nodes 2, each said node representing a junction wherein downstream optical signaling is converted to an electrical signal and carried via coax to drops at individual customer locations 3.

The coax network comprises mother lines each presenting a series of in cascade distributed signal amplifiers 5, called trunks 4. The lines are split by use of directional couplers 6, creating coupled line extenders or distribution lines 7. The latter include a number of (multi)taps 8 for the final signal distribution to subscribers (homes or companies) 3. Splitters are multi-way passive devices (2 to 8 output ports) which distinguish themselves from directional couplers in that they divide the RF signals evenly at the output ports, while directional couplers do not.

Traditional multitaps have recently been replaced by the so-called "plug-in" technology, the passive line remaining unchanged. Formerly, considering for example a 4-way multitap, taps were installed at the front of houses with four outputs provided with possible bulky external filters. A lot of drawbacks came along with this design: ugliness, bad contacts, possible fraud, etc. In the plug-in technology, all the components are included in a case, with a number of advantages over traditional multitaps: no more external filters and parameters adjustable electronically, possibility to provide anti-fraud screws, no more loops of cable (choice of the input direction), reliable contacts, etc.

CATV has known a strong technological revolution since the arrival of interactive applications, in particular related to Internet services, on a bidirectional network which has replaced the traditional one-way network. Typically, the cable plant is duplexed to allow upstream communication (subscriber to head-end) and downstream communication (head-end to subscriber). In the US, where data services operate under DOCSIS standards, the upstream bandwidth is 5 to 42 MHz and the downstream is 54 to 862 MHz. In Europe, where data services are directed by EuroDOCSIS standards, upstream is 5 to 65 MHz while downstream is 88 to 862 MHz.

Massive application has given birth to new products such as cable modems, network interface units, reverse step attenuators, etc. Network structure has also changed from the topology trunk - branch to the starry one. From the subscriber node, the former coaxial technology persists with trunk amplifiers, line extenders and passive line components like splitters, directional couplers and multitaps.

Cable modems are used to transmit upstream information from individual PC's back to the antenna station (head-end). A cable modem is a device that enables to hook up a PC to a local CATV line and receive data at about 1.5 Mbps. This data rate far exceeds that of the ones previously used (28.8 and 56 Kbps for phone modems and 128 Kbps for ISDN) and is about the data rate available using Digital Subscriber Line (DSL) phone service. Typically the cable modem attaches to a standard Ethernet card in the computer. A cable modem can also be added to or integrated with a set-top box that provides a TV set with channels for Internet access.

As losses may be very high between the head-end and each final subscriber, through the succession of cables, passive components such as couplers, etc., the cable modem needs to transmit very high level signal from 50 to 65 dBmV in order to overcome the loss in taps and directional couplers. As a negative consequence, the harmonic content of the signal dramatically increases, leading to perturbations.

A possible solution to solve this problem is known from EP-A-0 827 297, which discloses a directional coupler wherein downstream and upstream signals are attenuated by different amounts to allow upstream signals to be originated at individual subscribers at the same level yet be received at a common upstream amplifier at substantially the same level. Different attenuation of downstream and upstream signals is achieved by the combination of a pair of directional couplers and a diplex filter. The couplers and diplex filter collectively separate a downstream signal destined for the subscriber from an upstream signal generated by the subscriber.

### Aims of the invention

The present invention aims to provide a solution which permits to avoid the drawbacks of prior art.

Particularly the invention aims at providing a solution for reducing the upstream signal loss in the coaxial network line while maintaining the same loss in the downstream signal, in comparison with prior art.

A further aim of the invention is to limit insertion losses of the directional couplers in the trunk lines.

### Summary of the invention

A first object of the invention relates to a broadband RF directional coupler to be inserted in a coaxial transmission line belonging to a bidirectional CATV network, comprising one IN port for receiving an incoming downstream signal, one OUT or THROUGH port and at least one TAP port, said OUT port transmitting a first split signal in a trunk line and said TAP port transmitting a second split signal in an extender line, and comprising means for splitting the incoming signal at the IN port in a low frequency band component and a high frequency band component, for submitting each said component to a treatment and for recombining both treated components at the OUT port and at the TAP port, characterized in that said treatment means comprise a first directional coupler, acting on the high frequency band signal component, presenting asymmetrical through loss and tap loss, -x dB and -X dB respectively, and a second directional coupler (62'), acting on the low frequency band signal component, presenting through loss and tap loss, -y dB and -Y dB respectively, wherein Y ≤ X and preferably Y ≈ y ( x, X, y, Y > 0).

Preferably, said means for splitting and recombining signals are RF diplexers.

The invention may be practiced by way of example for a low frequency signal component comprised in the bandpass 5 to 65 MHz and a high frequency signal component comprised in the bandpass 54 MHz to 1 GHz.

Advantageously, upstream network communication is in the bandwidth 5 to 42 MHz or 5 to 65 MHz and downstream network communication is in the bandwidth 54 to 862 MHz or 88 to 862 MHz.

In a preferred embodiment of the present invention, X is comprised in the range 8 to 35 and Y is comprised in the range 3 to 8.

A second object of the invention relates to a directional tap or multi-tap, comprising a multi-way splitter directly connected in a single housing with a directional coupler as above-mentioned. The directional tap or multi-tap may be advantageously set up according to the "plug-in" technology.

Still another object of the invention concerns a RF coaxial network connected to a HFC node of a CATV bidirectional network, characterized in that distribution lines to subscribers are branched to mother trunk lines using directional couplers as above-mentioned.

Still another object of the invention concerns a RF coaxial network connected to a HFC node of a CATV bidirectional network, characterized in that drops at individual subscribers are realized by the means of multi-taps as above-mentioned.

### Short description of the drawings

Fig. 1, as already above-mentioned, represents schematically a typical HFC network architecture for CATV distribution.

Fig. 2 schematically represents a directional coupler with symmetrical insertion loss according to prior art.

Fig. 3 represents a RGST directional coupler according to the present invention, with an asymmetric insertion loss, i.e. a downstream loss which is different from the upstream loss.

Fig. 4 schematically represents an extended RGST directional coupler according to the present invention.

### Description of a preferred embodiment of prior art

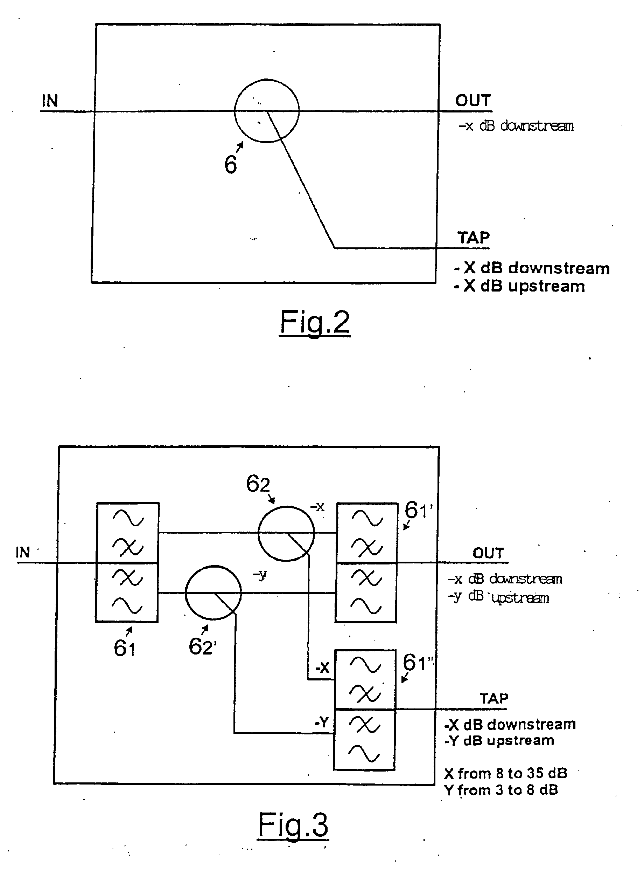

Figure 2 shows a traditional directional coupler. The input port (or terminal) IN of the coupler is connected to the upstream coaxial primary line and the output port OUT (or port THROUGH) is connected to the downstream coaxial primary line. These lines are provided with bidirectional amplifiers. The signal is also deviated to a secondary line at the coupler level (TAP port).

Conventionally supposing that the input signal is 0 dB, each component of the two-fold output signal has reduced intensity: - x dB at OUT port and - X at TAP port. The ratio x/X can be chosen to guaranty low loss along the primary line, for example - 1 dB at OUT and - 16 dB at TAP. Such RF directional couplers are known to be based on two interconnected transformers. The ratio x/X can be easily changed by modifying the turns ratios of said transformers (n1, n2). In this technology upstream loss is generally equal to downstream loss.

In order to increase the TAP-side signal intensity, the IN port signal may be amplified up to + 10 dB by use of a upstream 10 dB amplifier, thus leading to a -6 dB TAP signal. Such variations are accommodated by the common TV and PC tolerance.

In the upstream way the same loss, for example - 16 dB) is to be expected. In the case of traditional couplers with loss from -8 dB to -35 dB, the reverse signal loss lies within the range from -8 to -35 dB as well. This loss is too high and the cable modem has a lot of difficulties to properly reach the head-end station. Thus cable modem signal has to be amplified by 50 to 65 dBmV in order to accommodate losses in taps and directional couplers.

### Description of a preferred embodiment of the invention

In order to reduce the loss, the so-called RGST (Reverse Gain Saving Technology) is supported by an innovative idea to help cable modem not to work with so high signal input level as compared with what is required in prior art technology.

RGST is a technology to manufacture new directional couplers with low reverse insertion loss, justifying the way it is called. In filtering theory, insertion loss is an additional loss between source and load caused by inserting a device (insertion loss = dissipation loss + reflection or return loss).

The idea is thus to reduce this loss up to -3 or -4 dB maximum, while retaining the loss in the downstream line in the range from -8 to -35 dB in order to maintain a right TV signal-to-noise ratio for subscribers.

This principle is implemented according to the present invention as schematically described on figure 3.

In broadband RF technology, diplexers 61,61',61", known per se, are separators which produce a 2-way splitting (or recombination) of an incoming signal respectively into a high-frequency band first signal and a low-frequency band second signal. For example, the low pass filter passband may be comprised between 5 and 65 MHz and the high pass filter passband may be comprised between 88 MHz and ∼1 GHz. Each of both signals may consequently undergo a specific treatment 62,62', such as PI filtering, attenuation, etc., before both signals are again mixed or recombined using a diplexer of the same type.

According to a preferred embodiment of the present invention, said separated treatment for the low frequency signal and the high frequency signal are realized by inserting on each component between two diplexers a state-of-the-art directional coupler. At this point it is possible to adjust said couplers in order to differentiate the upstream and downstream losses. For example, in the high frequency band (downstream), on can choose -1 dB at the OUT terminal and - 16 dB at the TAP terminal, as it was the case formerly, while in the low frequency band (upstream), one can reduce the TAP loss at -4 dB, at the expense of a signal degradation at the OUT end, also equal to -4 dB (indeed, the higher the loss to the tap port, the lower the insertion loss to the out port).

It is thus a particular object of the invention to provide a RGST directional coupler with the following specifications at the TAP level: -X dB downstream, with X preferably comprised between 8 and 35, and -Y dB upstream, with Y preferably between 3 and 8.

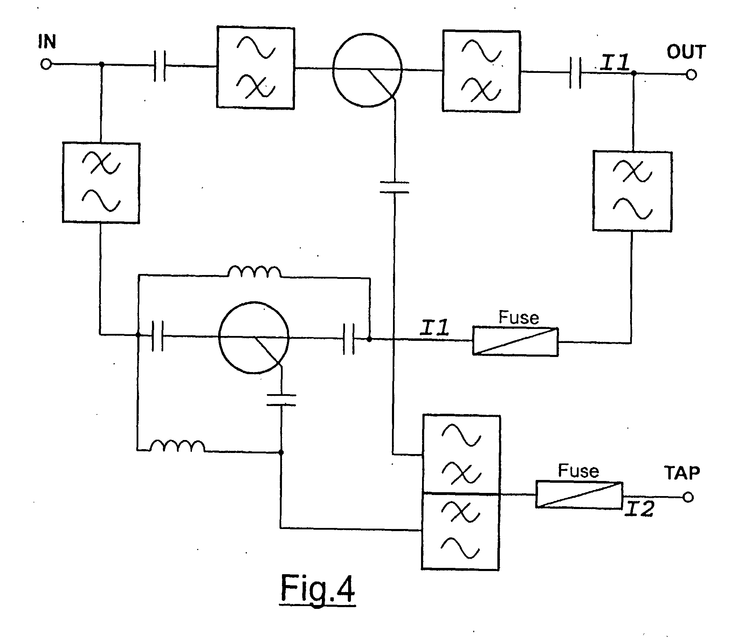

Figure 4 shows a extended preferred embodiment of the present invention corresponding to the accommodation of power passing of several amperes and fuse inserted in the circuit.

## Claims

1. Broadband RF directional coupler (6) to be inserted in a coaxial transmission line belonging to a bidirectional CATV network, comprising one IN port for receiving an incoming downstream signal, one OUT or THROUGH port and at least one TAP port, said OUT port transmitting a first split signal in a trunk line (4) and said TAP port transmitting a second split signal in an extender line (7), and comprising means for splitting (61) the incoming signal at the IN port in a low frequency band component and a high frequency band component, for submitting each said component to a treatment (62, 62') and for recombining (61', 61") both treated components at the OUT port and at the TAP port, **characterized in that** said treatment means comprise a first directional coupler (62), acting on the high frequency band signal component, presenting asymmetrical through loss and tap loss, -x dB and -X dB respectively, and a second directional coupler (62'), acting on the low frequency band signal component, presenting through loss and tap loss, -y dB and -Y dB respectively, wherein Y ≤ X and preferably Y ≈ y ( x, X, y, Y > 0).

2. Directional coupler (6) according to Claim 1, **characterized in that** said means for splitting and recombining signals are RF diplexers (61, 61', 61").

3. Directional coupler (6) according to Claim 1 or 2, **characterized in that** the low frequency signal component is comprised in the bandpass 5 to 65 MHz and the high frequency signal component is comprised in the bandpass 54 MHz to 1 GHz.

4. Directional coupler (6) according to any one of Claims 1 to 3, **characterized in that** upstream network communication is in the bandwidth 5 to 42 MHz or 5 to 65 MHz.

5. Directional coupler (6) according to any one of Claims 1 to 3, **characterized in that** downstream network communication is in the bandwidth 54 to 862 MHz or 88 to 862 MHz.

6. Directional coupler (6) according to any one of the preceding Claims, **characterized in that** X is comprised in the range 8 to 35 and Y is comprised in the range 3 to 8.

7. Directional tap or multi-tap (8), comprising a multi-way splitter directly connected in a single housing with a directional coupler according to anyone of Claims 1 to 6.

8. Directional tap or multi-tap (8) according to Claim 7, **characterized in that** it is set up according to the "plug-in" technology.

9. RF coaxial network connected to a HFC node of a CATV bidirectional network, **characterized in that** distribution lines to subscribers are branched to mother trunk lines using directional couplers (6) according to anyone of Claims 1 to 6.

10. RF coaxial network connected to a HFC node of a CATV bidirectional network, **characterized in that** drops at individual subscribers are realized by the means of multi-taps (8) according to Claim 7 or 8.

## Patentansprüche

1. Ein Breitband-HF-Richtungskoppler (6) ist in eine koaxiale Übertragungsleitung einzubringen, die zu einem bidirektionalen CATV-Netzwerk gehört. Dieses umfasst einen Port EIN für den Empfang des ankommenden Downstream-Signals, einen Port AUS oder DURCH und mindestens einen TAP-Port. Der besagte AUS-Port überträgt das erste Split-Signal über eine Hauptleitung (4), während der besagte TAP-Port ein zweites Split-Signal über eine Nebenleitung überträgt (7). Das Netzwerk umfasst ferner eine Vorrichtung (61), mit der das ankommende Signal am EIN-Port in eine Komponente im Niederfrequenzband und in eine Komponente im Hochfrequenzband aufgeteilt werden kann, so dass jede der besagten Komponenten einer Verarbeitung zugeführt (62, 62') und damit beide verarbeiteten Komponenten (61',61'') am AUS-Port und am TAP-Port erneut kombiniert werden können. Das Verfahren zeichnet sich dadurch aus, dass in den Vorkehrungen zur besagten Verarbeitung ein erster Richtungskoppler enthalten ist (62), der auf die Komponente des hochfrequenten Bandsignals wirkt, asymmetrische Durchgangs- und Anschaltdämpfung, -x dB und beziehungsweise -X dB, aufweist sowie ein zweiter Richtungskoppler (62'), der auf die Komponente des niederfrequenten Bandsignals wirkt und Durchgangs- und Anschaltdämpfung, jeweils -y dB und beziehungsweise -Y dB, mit Y ≤ X und bevorzugt Y ≈ y (x, X, y, Y > 0) aufweist.

2. Richtungskoppler (6) entsprechend Anspruch 1, der **dadurch gekennzeichnet ist, dass** es sich bei besagten Vorrichtungen zur Aufteilung und erneuten Kombination der Signale um HF-Frequenzweichen handelt (61, 61', 61'').

3. Richtungskoppler (6) entsprechend den Ansprüchen 1 oder 2, der **dadurch gekennzeichnet ist, dass** die niederfrequente Signalkomponente im Bandpass 5 bis 65 MHz liegt, während die hochfrequente Signalkomponente im Bandpass 54 MHZ bis 1 GHz liegt.

4. Richtungskoppler (6) entsprechend einem der Ansprüche 1 bis 3, der **dadurch gekennzeichnet ist, dass** die Upstream-Netzwerkkommunikation in der Bandbreite 5 bis 42 MHz bzw. 5 bis 65 MHz stattfindet.

5. Richtungskoppler (6) entsprechend einem der Ansprüche 1 bis 3, der **dadurch gekennzeichnet ist, dass** die Downstream-Netzwerkkommunikation in der Bandbreite 54 bis 862 MHz bzw. 88 bis 862 MHz stattfindet.

6. Richtungskoppler (6) entsprechend einem der zuvor genannten Ansprüche, der **dadurch gekennzeichnet ist, dass** x im Bereich 8 bis 35 und y im Bereich 3 bis 8 liegt.

7. Richtungsgebundener Tap- oder Mehrfach-Tap-Anschluss (8), der einen Mehrwege-Splitter enthält, der in einem Gehäuse direkt mit einem Richtungskoppler entsprechend einem der Ansprüche 1 bis 6 verbunden ist.

8. Richtungsgebundener Tap- oder Mehrfach-Tap-Anschluss (8) entsprechend Anspruch 7, der **dadurch gekennzeichnet ist, dass** er gemäß der "Plug-In"-Technologie eingerichtet ist.

9. Ein HF-Koaxial-Netzwerk, das an einen HFC-Knoten eines bidirektionalen CATV-Netzwerks angeschlossen ist, das **dadurch gekennzeichnet ist, dass** die Verteilerleitungen zu den Nutzern von den einspeisenden Hauptleitungen mit Hilfe von Richtungskopplern (6) entsprechend einem der Ansprüche 1 bis 6 verzweigt werden.

10. Ein HF-Koaxial-Netzwerk, das an einen HFC-Knoten eines bidirektionalen CATV-Netzwerks angeschlossen ist, das **dadurch gekennzeichnet ist, dass** die Abnehmer an den einzelnen Nutzern mit Hilfe von Mehrfach-Tap-Anschlüssen (8) entsprechend der Ansprüche 7 oder 8 realisiert werden.

## Revendications

1. Coupleur directionnel radiofréquence à large bande (6) destiné à être introduit dans une ligne de transmission coaxiale appartenant à un réseau bidirectionnel de télévision par câble, comprenant un port IN pour recevoir un signal entrant en aval, un port OUT ou THROUGH et au moins un port TAP, ledit port OUT transmettant un premier signal fractionné sur une ligne principale (4) et ledit port TAP transmettant un second signal fractionné sur une ligne de dérivation (7), et comprenant des moyens pour fractionner (61) le signal entrant au port IN dans une composante de bande à basse fréquence et une composante de bande à haute fréquence, des moyens pour soumettre chacune desdites composantes à un traitement (62, 62') et des moyens pour recombiner (61, 61') les deux composantes traitées au port OUT et au port TAP, **caractérisé en ce que** ledit moyen de traitement comprend un premier coupleur directionnel (62) agissant sur la composante du signal de bande à haute fréquence, présentant une perte de transit et une perte de dérivation asymétriques, respectivement -x dB et -X dB, et un second coupleur directionnel (62') agissant sur la composante du signal de bande à basse fréquence, présentant une perte de transit et une perte de dérivation, respectivement -y dB et -Y dB, où Y ≤ X et de préférence Y ≈ y (x, X, y, Y > 0).

2. Coupleur directionnel (6) selon la revendication 1, **caractérisé en ce que** ledit moyen de fractionnement et de recombinaison des signaux consiste en des diplexeurs radiofréquence (61, 61', 61").

3. Coupleur directionnel (6) selon la revendication 1 ou 2, **caractérisé en ce que** la composante du signal à basse fréquence est comprise dans la bande passante de 5 à 65 MHz et que la composante du signal à haute fréquence est comprise dans la bande passante de 54 MHz à 1 GHz.

4. Coupleur directionnel (6) selon l'une quelconque des revendications 1 à 3, **caractérisé en ce que** la communication en réseau amont est incluse dans la largeur de bande de 5 à 42 MHz ou de 5 à 65 MHz.

5. Coupleur directionnel (6) selon l'une quelconque des revendications 1 à 3, **caractérisé en ce que** la communication en réseau aval est incluse dans la largeur de bande de 54 à 862 MHz ou de 88 à 862 MHz.

6. Coupleur directionnel (6) selon l'une quelconque des revendications précédentes, **caractérisé en ce que** X est inclus dans la plage de 8 à 35 et Y est inclus dans la plage de 3 à 8.

7. Dérivation directionnelle ou multi-dérivation (8) comprenant un répartiteur multivoies directement connecté dans un logement unique à un coupleur directionnel selon l'une quelconque des revendications 1 à 6.

8. Dérivation directionnelle ou multi-dérivation (8) selon la revendication 7, **caractérisée en ce qu'**elle est conforme à la technologie « plug-in ».

9. Réseau radiofréquence coaxial connecté au noeud hybride fibre optique-câble coaxial d'un réseau bidirectionnel de télévision par câble, **caractérisé en ce que** les lignes de distribution des abonnés sont branchées sur des lignes-mères faisant appel à des coupleurs directionnels (6) selon l'une quelconque des revendications 1 à 6.

10. Réseau radiofréquence coaxial connecté au noeud hybride fibre optique-câble coaxial d'un réseau bidirectionnel de télévision par câble, **caractérisé en ce que** les branchements des abonnés individuels sont réalisés au moyen des multi-dérivations (8) selon la revendication 7 ou 8.
